# FASCICULE DE BREVET EUROPEEN

(11) **EP 3 923 150 B1**
(45) Date de publication et mention de la délivrance du brevet: **20.03.2024**
(21) Numéro de dépôt: 21177016.9
(22) Date de dépôt: 01.06.2021
(51) Int. Cl.: G06F 13/16

(54) **PROCÉDÉ DE GESTION DES REQUÊTES D'ACCÈS À UNE MÉMOIRE VIVE ET SYSTÈME CORRESPONDANT**
VERFAHREN ZUR VERWALTUNG VON ZUGRIFFSANFRAGEN AUF EINEN DIREKTZUGRIFFSSPEICHER UND ENTSPRECHENDES SYSTEM
METHOD FOR MANAGING REQUESTS FOR ACCESS TO A RANDOM ACCESS MEMORY AND CORRESPONDING SYSTEM

(30) Priorité: 12.06.2020 FR 2006167
(43) Date de publication de la demande: 15.12.2021
(73) Titulaire: STMicroelectronics (Rousset) SAS, 13790 Rousset (FR)
(72) Inventeur: EVA, Christophe, 13790 ROUSSET (FR); GRIL-MAFFRE, Jean-Michel, 13090 AIX EN PROVENCE (FR)
(74) Mandataire: Casalonga

(56) Documents cités:
- US-A1- 2016 335 000
- US-B1- 6 356 987
- SABNIS A V ET AL: "1553B communication using DSP based digital controller", PROCEEDINGS OF THE 2014 INTERNATIONAL CONFERENCE ON CONTROL, INSTRUMENTATION, ENERGY AND COMMUNICATION (CIEC), IEEE, 31 janvier 2014 (2014-01-31), pages 485-489, XP032684274, DOI: 10.1109/CIEC.2014.6959136
- Texas Instruments Incorporated: "TMS320x2833x, 2823x DSC External Interface (XINTF) Reference Guide", , 1 January 2010 (2010-01-01), pages 1-38, XP93011277, Retrieved from the Internet: URL:https://mil.ufl.edu/3744/docs/TI_DSP/T I-docs/spru949d.pdf [retrieved on 2023-01-03]

## Description

Des modes de réalisation et de mise en oeuvre de l'invention concernent le domaine de la microélectronique et plus particulièrement le domaine de la gestion des accès à des mémoires vives, par exemple du type « RAM », du type « DRAM », ou du type « SRAM » (acronymes des termes anglais usuels « Random Access Memory », « Dynamic Random Access Memory » et « Static Random Access Memory »).

Des dispositifs électroniques classiques comprennent par exemple un processeur connecté à une mémoire vive par l'intermédiaire de bus et d'une interface mémoire. Le processeur peut émettre une requête d'accès destinée à la mémoire vive en lecture ou en écriture, via les bus et l'interface mémoire.

Typiquement les performances de la mémoire vive baissent lorsque la tension d'alimentation diminue, notamment en raison de l'augmentation des temps d'accès en lecture et en écriture.

Pour ne pas pénaliser la performance en fréquence du processeur, l'interface mémoire met en oeuvre un mécanisme d'état d'attente (« wait state » en anglais) permettant à l'interface d'indiquer au processeur une non disponibilité de la mémoire vive pendant un nombre fixé de cycles d'horloge suivant une réception de la requête d'accès.

De ce fait certaines opérations effectuées par le processeur durent plus longtemps, ce qui est pénalisant en termes de consommation, tout particulièrement dans des modes de fonctionnement à basse tension, destinés à présenter une consommation moindre.

Il existe donc un besoin d'améliorer les performances basses tension de tels dispositifs électroniques.

Il est connu de SABNIS A V ET AL: "1553B communication using DSP based digital controller",PROCEEDINGS OF THE 2014 INTERNATIONAL CONFERENCE ON CONTROL, INSTRUMENTATION, ENERGY AND COMMUNICATION (CIEC), IEEE, 31 janvier 2014 (2014-01-31), pages 485-489, XP032684274,DOI: 10.1109/CIEC.2014.6959136 un système de programmation des temps d'indisponibilité d'une mémoire vive pour des accès en lecture et écriture.

Les inventeurs ont observé qu'un temps d'accès pour écrire du contenu dans la mémoire vive est moins sensible aux variations de tension d'alimentation de la mémoire qu'un temps d'accès pour lire du contenu et que par conséquent, en particulier à basse tension, le temps d'accès pour écrire du contenu dans la mémoire vive est plus court que le temps d'accès pour lire du contenu.

Selon un mode de mise en oeuvre et de réalisation il est donc proposé d'ajuster sélectivement le temps d'attente entre deux requêtes d'accès en fonction de la lecture ou de l'écriture de contenu dans la mémoire vive.

Ceci permet en particulier de ne pas forcer le processeur à attendre le même temps pour pouvoir effectuer une opération après une requête en écriture à la mémoire, que celui pour pouvoir effectuer une opération après une requête en lecture à la mémoire, alors que la mémoire serait en fait déjà disponible.

Selon un aspect, il est proposé un procédé de gestion des accès à une mémoire vive connectée à une unité de traitement par l'intermédiaire d'une interface mémoire.

Le procédé selon cet aspect comprend à la réception par l'interface mémoire d'une requête d'accès à la mémoire émise par l'unité de traitement, une indication par l'interface mémoire à l'unité de traitement de la non disponibilité de la mémoire pour recevoir une autre requête d'accès pendant une durée d'indisponibilité différentiable selon que la requête reçue est une requête en écriture ou en lecture.

Par ailleurs la valeur de la durée d'indisponibilité associée à une requête en écriture et la valeur de la durée d'indisponibilité associée à une requête en lecture sont individuellement programmables indépendamment l'une de l'autre.

Ces durées d'indisponibilités programmables sont à distinguer des durées intrinsèques des opérations d'écritures et/ou de lectures effectuées en interne par la mémoire elle-même.

Ces valeurs de durée d'indisponibilité en lecture et en écriture sont programmables, par exemple par un utilisateur du microcontrôleur, et ce indépendamment l'une de l'autre, par exemple en fonction de caractéristiques de l'application envisagée, telles que la tension d'alimentation et de la fréquence de fonctionnement souhaitées.

De par cette programmation, par exemple par stockage de ces valeurs dans des registres, c'est l'utilisateur qui choisit ces valeurs de durées d'indisponibilités, indépendamment des durées intrinsèques des opérations d'écriture et/ou de lecture effectués par la mémoire elle-même.

Par exemple l'utilisateur peut imposer un nombre non nul de cycle(s) d'horloge (correspondant à la durée d'indisponibilité) pendant lequel ou lesquels la mémoire sera considérée comme indisponible vue de l'unité de traitement, ce qui permet de garantir que l'opération d'écriture ou de lecture effectuée par la mémoire sera bien terminée avant la réception d'une autre requête d'accès et donc de garantir un fonctionnement correct du microcontrôleur, compte tenu de la fréquence envisagée.

Une durée d'indisponibilité, par exemple en écriture, programmée à une valeur nulle signifie que l'on considère que la durée intrinsèque de l'opération considérée, par exemple l'opération d'écriture, est compatible avec un fonctionnement correct du microcontrôleur compte tenu de la fréquence envisagée.

Par conséquent dans ce cas, l'utilisateur n'impose rien et laisse la mémoire et l'interface mémoire opérer de façon classique.

Comme il a été observé que le temps d'accès pour écrire du contenu dans la mémoire vive est plus court que le temps d'accès pour lire du contenu, en particulier à basse tension, la durée d'indisponibilité associée à une requête en écriture peut être alors avantageusement choisie inférieure à la durée d'indisponibilité associée à une requête en lecture.

Ceci permet alors de limiter la durée pendant laquelle l'unité de traitement ne peut pas exécuter d'opérations suite à une demande d'écriture dans la mémoire, ce qui permet une moindre consommation (moins de cycles d'horloges pendant lesquels l'unité de traitement n'exécute aucune opérations) et une plus grande rapidité d'exécutions de certaines opérations.

Selon les cas envisagés, ces valeurs programmables peuvent être toutes les deux non nulles, ou bien nulle pour l'une et non nulle pour l'autre, ou encore nulles toutes les deux, par exemple si les durées intrinsèques des opérations de lecture et/ou d'écriture, même augmentées, ne sont pas préjudiciables au bon fonctionnement du microcontrôleur, par exemple lors d'un fonctionnement à basse tension mais à également à basse fréquence.

De même la durée la durée d'indisponibilité associée à une requête en écriture peut être dans certains cas choisie égale à la durée d'indisponibilité associée à une requête en lecture, en particulier en l'absence de « wait state ».

Selon un mode de mise en oeuvre, l'unité de traitement est cadencée par un signal d'horloge, et la valeur de la durée d'indisponibilité associée à une requête en écriture ainsi que la valeur de la durée d'indisponibilité associée à une requête en lecture peuvent dépendre, comme indiqué ci-dessus, de la valeur de tension d'alimentation de la mémoire vive et de la fréquence du signal d'horloge.

En effet, comme indiqué ci-dessus, même si les temps d'accès à la mémoire augmentent avec une baisse de la tension d'alimentation, ceci peut ne pas être gênant si par exemple la fréquence de cadencement de l'unité de traitement reste faible. L'utilisateur peut alors décider de ne pas augmenter la durée d'indisponibilité de la mémoire au-delà du temps d'accès inhérent à la mémoire à basse tension.

Selon un mode de mise en oeuvre, la valeur de durée d'indisponibilité associée à requête en lecture est non nulle si la tension d'alimentation est inférieure à un premier seuil et si la fréquence est supérieure à un deuxième seuil, et la valeur de la durée d'indisponibilité associée à requête en écriture est non nulle si la tension d'alimentation est inférieure à un troisième seuil et si la fréquence est supérieure à un quatrième seuil.

Le premier seuil et le troisième seuil peuvent être identiques ou différents.

Cela étant, en général le premier seuil est supérieur au troisième seuil.

Par exemple pour une tension d'alimentation supérieure à 1 volt, la valeur de la durée d'indisponibilité associée à requête en lecture et la valeur de la durée d'indisponibilité associée à requête en écriture pourront être choisies toutes les deux nulles, pour une fréquence donnée.

Par contre si la tension d'alimentation est comprise entre 0,8 volt et 1 volt, la valeur de la durée d'indisponibilité associée à une requête en lecture sera choisie non nulle tandis que la valeur de la durée d'indisponibilité associée à une requête en écriture sera toujours nulle, par exemple.

Et pour une tension d'alimentation inférieure à 0,8 volt, la valeur de la durée d'indisponibilité associée à une requête en lecture et la valeur de la durée d'indisponibilité associée à une requête en écriture pourront être choisies toutes les deux non nulles.

Le deuxième seuil et le quatrième seuil peuvent être aussi identiques ou différents.

En général une fréquence souhaitée élevée conduit à des durées d'indisponibilités non nulles.

Ainsi, avoir des seuils personnalisables individuellement en lecture ou en écriture pour déclencher une période d'indisponibilité permet de prendre en compte les différences d'évolutions de temps d'accès en lecture et en écriture en fonction de la tension d'alimentation et de la fréquence.

Comme indiqué précédemment, selon un mode de mise en oeuvre, lorsque l'unité de traitement est cadencée par un signal d'horloge, la valeur de la durée d'indisponibilité associée à une requête en écriture correspond à un premier nombre de cycles du signal d'horloge et la valeur de la durée d'indisponibilité associée à une requête en lecture correspond à un deuxième nombre de cycles du signal d'horloge.

Ceci permet alors d'utiliser des compteurs pour matérialiser ces valeurs de durées d'indisponibilités.

Selon un autre aspect, il est proposé un système, comprenant une mémoire vive connectée à une unité de traitement par l'intermédiaire d'une interface mémoire.

L'invention est définie par le jeu des revendications. Les revendications dépendantes définissent des modes de réalisation particuliers.

Ladite interface mémoire comporte des moyens de réception configurés pour recevoir une requête d'accès à la mémoire émise par l'unité de traitement, et des moyens de traitement connectés aux moyens de réception et configurés pour indiquer à l'unité de traitement la non disponibilité de la mémoire vive pour recevoir une autre requête d'accès pendant une durée d'indisponibilité différentiable selon que la requête reçue est une requête en écriture ou en lecture.

Le système comprend en outre des moyens de programmation configurés pour programmer individuellement indépendamment l'une de l'autre la valeur de la durée d'indisponibilité associée à une requête en écriture et la valeur de la durée d'indisponibilité associée à une requête en lecture.

Selon un mode de réalisation, l'unité de traitement est cadencée par un signal d'horloge, et la valeur de la durée d'indisponibilité associée à une requête en écriture ainsi que la valeur de la durée d'indisponibilité associée à une requête en lecture dépendent de la valeur de tension d'alimentation de la mémoire vive et de la fréquence du signal d'horloge.

Selon un mode réalisation, la valeur de la durée d'indisponibilité associée à une requête en lecture est non nulle si la tension d'alimentation est inférieure à un premier seuil et si la fréquence est supérieure à un deuxième seuil, et la valeur de la durée d'indisponibilité associée à une requête en écriture est non nulle si la tension d'alimentation est inférieure à un troisième seuil et si la fréquence est supérieure à un quatrième seuil.

Selon un mode réalisation, la durée d'indisponibilité associée à une requête en écriture est inférieure ou égale à la durée d'indisponibilité associée à une requête en lecture.

Selon un mode réalisation, l'unité de traitement est cadencée par un signal d'horloge, la valeur de la durée d'indisponibilité associée à une requête en écriture correspond à un premier nombre de cycles du signal d'horloge et la valeur de la durée d'indisponibilité associée à une requête en lecture correspond à un deuxième nombre de cycles du signal d'horloge.

Selon un mode réalisation, les moyens de traitement comportent
- un premier compteur cadencé par le signal d'horloge et ayant une première valeur de fin de comptage correspondant à la valeur de la durée d'indisponibilité associée à une requête en écriture,
- un deuxième compteur cadencé par le signal d'horloge et ayant une deuxième valeur de fin de comptage correspondant à la valeur de la durée d'indisponibilité associée à une requête en lecture, et
- une machine d'état configurée pour
   déclencher le premier compteur ou le deuxième compteur si la première valeur de fin de comptage ou la deuxième valeur de fin de comptage est respectivement non nulle,
   délivrer un signal d'indisponibilité de la mémoire à l'unité de traitement lors du déclenchement de l'un des compteurs et
   délivrer un signal de disponibilité de la mémoire à l'unité de traitement lorsque le compteur ayant été déclenché a atteint sa valeur de fin de comptage.

Selon un mode réalisation, les moyens de programmation comportent -un premier moyen de mémorisation programmable connecté aux moyens de traitement et destiné à contenir une première indication représentative de la valeur de la durée d'indisponibilité associée à une requête en écriture, et -un deuxième moyen de mémorisation programmable connecté aux moyens de traitement et destiné à contenir une deuxième indication représentative de la valeur de la durée d'indisponibilité associée à une requête en lecture.

Selon un mode réalisation, ladite première indication est la première valeur de fin de comptage et ladite deuxième indication est la deuxième valeur de fin de comptage.

Selon un mode de réalisation le système forme un microcontrôleur.

D'autres avantages et caractéristiques de l'invention apparaîtront à l'examen de la description détaillée de modes de réalisation et de mise en oeuvre, nullement limitatifs, et des dessins annexés sur lesquels :
[Fig 1] ;
[Fig 2] ;

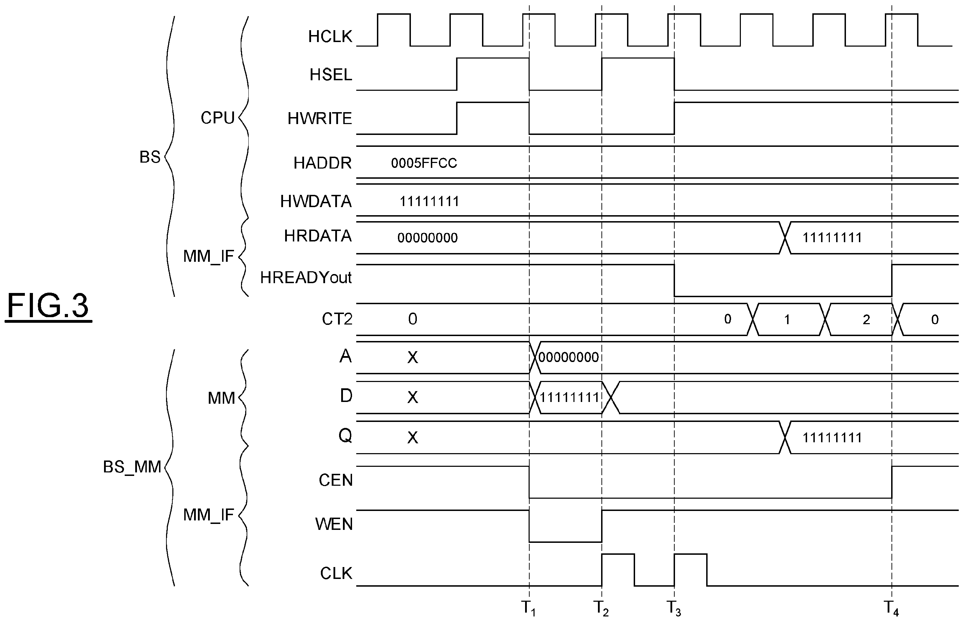

[Fig 3] illustrent des modes de réalisation et de mise en oeuvre de l'invention.

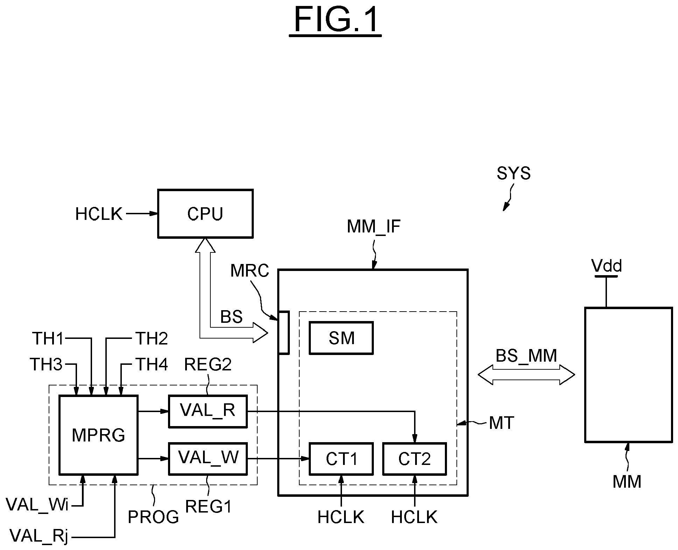

La figure 1 illustre un système SYS comprenant une mémoire vive MM, typiquement statique ou dynamique, connectée à une unité de traitement CPU, par exemple un processeur, par l'intermédiaire d'une interface mémoire MM_IF. Le terme « mémoire vive » s'entend ici d'une façon globale, en ce sens que la mémoire vive MM peut être par exemple composée d'une ou de plusieurs de mémoires vives. La mémoire vive MM est alimentée par une tension d'alimentation Vdd.

L'unité de traitement CPU est cadencée par un signal d'horloge HCLK ayant une fréquence Freq.

La connexion entre l'unité de traitement CPU et l'interface mémoire MM_IF est réalisée par un bus BS, par exemple du type AHB (acronyme anglais signifiant « Advanced High-performance Bus »), ou plus généralement par un bus correspondant à la norme « AMBA » (acronyme anglais signifiant « Advanced Microcontroller Bus Architecture »).

De même, la connexion entre l'interface mémoire MM_IF et la mémoire vive MM est réalisée par un bus mémoire BS_MM.

Le système SYS ainsi formé peut être par exemple un microcontrôleur intégré dans un appareil mobile tel qu'un téléphone mobile, par exemple un microcontrôleur de la gamme STM32 commercialisé par la société STMicroelectronics.

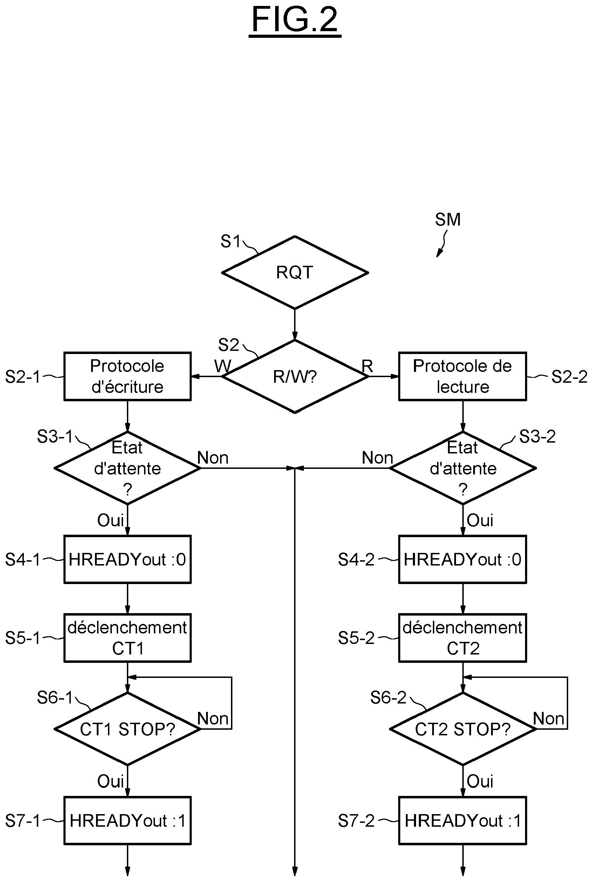

Lors du fonctionnement du système SYS, l'unité de traitement CPU émet des requêtes d'accès en lecture ou en écriture RQT (figure 2) destinées à la mémoire vive MM via les bus BS, BS_MM.

L'interface mémoire MM_IF comporte à cette fin des moyens de réception MRC configurés pour recevoir une telle requête d'accès RQT.

Dans certaines applications, on cherche typiquement à minimiser la consommation électrique du système SYS et, en particulier, il est avantageux de diminuer la consommation électrique de la mémoire vive MM qui est classiquement l'un des composants les plus énergivores en microélectronique.

Il existe par ailleurs des modes basse consommation, dans lesquels on diminue volontairement la tension d'alimentation Vdd de la mémoire.

Cependant diminuer la tension d'alimentation Vdd de la mémoire vive MM, a pour conséquence d'augmenter les temps d'accès à la mémoire vive en lecture et en écriture.

Un problème peut alors survenir lorsque la mémoire vive MM traite une requête d'accès RQT courante et qu'une nouvelle requête d'accès est reçue alors que la mémoire n'a pas encore terminé d'écrire ou de lire la donnée requise par la requête courante.

L'interface mémoire MM_IF comprend donc des moyens de traitement MT configurés pour mettre en oeuvre un mécanisme d'état d'attente (« wait state ») permettant d'indiquer à l'unité de traitement CPU l'indisponibilité de la mémoire vive MM pour une durée dite d'indisponibilité.

A cet effet, les moyens de traitement MT comprennent une machine d'état SM capable de générer un signal de disponibilité HREADYout (figure 2) qui est communiqué à l'unité de traitement CPU via le bus BS.

Le signal de disponibilité HREADYout est par exemple un signal binaire indiquant à l'état haut que la mémoire MM est disponible, et à l'état bas que la mémoire MM est non disponible. Lorsque le signal de disponibilité HREADYout reçu par l'unité de traitement CPU est à l'état bas alors l'émission d'une nouvelle requête d'accès à destination de la mémoire vive MM est inhibée.

Avantageusement, la machine d'état SM permet d'ajuster sélectivement une durée d'indisponibilité de la mémoire vive MM selon que la requête d'accès RQT est en lecture ou en écriture.

La durée d'indisponibilité associée à une requête en lecture est référencée VAL_R et la durée d'indisponibilité associée à une requête en écriture est référencée VAL_W.

Les durées d'indisponibilités VAL_R et VAL_W peuvent être identiques ou différentes et elles sont programmables, par exemple par l'utilisateur du système SYS.

Les moyens de traitement MT comportent un premier compteur CT1 et un deuxième compteur CT2 cadencés par le signal d'horloge HCLK de l'unité de traitement CPU.

Le premier compteur CT1 comprend une valeur de fin de comptage qui correspond à la durée d'indisponibilité VAL_W. Le deuxième compteur CT2 comprend une valeur de fin de comptage qui correspond à la durée d'indisponibilité VAL_R.

Comme il sera expliqué plus en détail en relation avec la figure 2, suite à une requête en écriture, et en supposant que VAL_W ne soit pas nulle, le premier compteur CT1 est configuré pour s'incrémenter au rythme du signal d'horloge HCLK, jusqu'à la valeur de durée d'indisponibilité en écriture VAL_W.

Suite à une requête en lecture, et en supposant que VAL_R ne soit pas nulle, le deuxième compteur CT2 est configuré pour s'incrémenter au rythme du signal d'horloge HCLK, jusqu'à la valeur de durée d'indisponibilité en lecture VAL_R.

Par ailleurs, le système SYS comprend également des moyens de programmation PROG comprenant un circuit de programmation MPRG afin de permettre à un utilisateur, comme indiqué ci-avant, de programmer individuellement les valeurs de durée d'indisponibilité en écriture VAL_W et en lecture VAL_R.

Les moyens de programmation PROG comprennent également un premier moyen de mémorisation REG1, par exemple un registre, stockant la valeur de durée d'indisponibilité en écriture VAL_W, et un deuxième moyen de mémorisation REG2, par exemple un registre, stockant la valeur de durée d'indisponibilité en lecture VAL_R. Le premier et le deuxième moyen de mémorisation REG1, REG2, sont respectivement connectés aux premier et deuxième compteurs CT1 et CT2 des moyens de traitement MT.

Les valeurs de durée d'indisponibilité en lecture VAL_R et en écriture VAL_W sont déterminées par exemple en fonction de la fréquence Freq de l'unité de traitement CPU et de la tension d'alimentation Vdd de la mémoire vive MM.

Afin de déterminer les durées d'indisponibilités, l'utilisateur peut par exemple définir un jeu de premières valeurs de fin de comptage en écriture VAL_Wi, et un jeu de deuxièmes valeurs de fin de comptage en lecture VAL_Rj, en fonction de plages de valeurs de tension d'alimentation Vdd de la mémoire vive MM et de fréquences Freq de l'unité de traitement CPU (fréquence du signal d'horloge HCLK).

A cet égard l'utilisateur peut par exemple utiliser un premier seuil TH1 de tension d'alimentation, un deuxième seuil TH2 de fréquence, un troisième seuil TH3 de tension d'alimentation et un quatrième seuil TH4 de fréquence.

Bien entendu le nombre de seuils peut être différent de quatre en fonction de l'application envisagée.

Ainsi, par exemple, la valeur de la durée d'indisponibilité associée à requête en lecture peut être non nulle si la tension d'alimentation Vdd est inférieure au premier seuil TH1 et si la fréquence Freq est supérieure au deuxième seuil TH2.

Par contre si la tension d'alimentation Vdd est inférieure au premier seuil TH1 mais que l'unité de traitement CPU travaille lentement, alors la durée d'indisponibilité associée à requête en lecture peut être nulle, c'est-à-dire que l'on ne passe pas dans un mécanisme d'état d'attente (pas de « wait state »).

De même, la valeur de la durée d'indisponibilité associée à requête en écriture peut être non nulle si la tension d'alimentation Vdd est inférieure au troisième seuil TH3, en pratique inférieur au premier seuil TH1, et si la fréquence Freq est supérieure au quatrième seuil TH4.

Si par contre la tension d'alimentation est supérieure au troisième seuil TH3, alors la durée d'indisponibilité associée à la requête en écriture peut être nulle.

Par exemple, pour une tension d'alimentation Vdd inférieure ou égale à 0,9 volt (TH1) et une fréquence de travail inférieure à 12 MHz (TH2), la durée d'indisponibilité en lecture VAL_R et en écriture VAL_W sont nulles (pas de « wait state »).

Pour une tension d'alimentation Vdd inférieure ou égale à 0,9 volt (TH1) mais supérieure à 0,7 volt (TH3) et une fréquence de travail supérieure à 12 MHz (TH2), la durée d'indisponibilité en lecture VAL_R peut être par exemple égale à deux ou trois cycles d'horloge HCLK et la durée d'indisponibilité en écriture VAL_W peut rester nulle (pas de « wait state »).

Pour une tension d'alimentation inférieure ou égale à 0,7 volt à 0,7 volt (TH3) et une fréquence de travail supérieure à 12 MHz (TH2=TH4), la durée d'indisponibilité en lecture VAL_R peut être par exemple égale à deux ou trois cycles d'horloge HCLK et la durée d'indisponibilité en écriture VAL_W peut être égale à un cycle d'horloge HCLK.

L'utilisateur peut donc programmer les différentes valeurs de seuils THi ainsi que les différentes valeurs de fin de comptage en lecture VAL_Rj et en écriture VAL_Wi compte tenu de ces seuils.

Toutes les valeurs de fin de comptage VAL_Rj, VAL_Wi ainsi que les valeurs des seuils sont stockées dans des moyens de mémoire, par exemple des registres.

Les moyens de programmation MPRG sont alors configurés pour sélectionner, en fonction de la tension d'alimentation Vdd de la mémoire MM et de la fréquence du signal d'horloge HCLK, la paire appropriée de valeurs de fin de comptage VAL_Rj, VAL_Wi et pour les stocker dans les registres REG2 et RGEG1, respectivement.

Comme indiqué ci-avant, les contenus de ces deux registres indiquent les valeurs de fin de comptage des deux compteurs CT1 et CT2.

Le mécanisme d'état d'attente (« wait state ») est désactivé en écriture et/ou en lecture lorsque la valeur de durée d'indisponibilité VAL_W et/ou VAL_R stockée dans les registres REG1, REG2 est nulle, respectivement.

Les moyens de programmation MPRG peuvent sélectionner la paire appropriée de valeurs de fin de comptage VAL_Wi, VAL_Rj, et les stocker dans les registres REG1, REG2 respectivement, par exemple à l'initialisation du système, en fonction par exemple du mode de fonctionnement prévu.

Les moyens de programmation MPRG peuvent aussi être configurés en outre pour adapter de manière dynamique les valeurs de durées d'indisponibilité en lecture VAL_R et ou en écriture VAL_W en fonction des valeurs courantes de la tension d'alimentation Vdd et de la fréquence Freq.

En effet, durant le fonctionnement du système SYS, si la tension d'alimentation Vdd et/ou la fréquence Freq dépasse un des seuils Thi (TH1, TH2, TH3, TH4) dans un sens ou un autre, par exemple lors d'un passage d'un mode pleine consommation à un mode basse consommation ou inversement, alors les moyens de programmations MPRG modifient la ou les valeurs stockées dans le ou les registres REG1, REG2, afin de correspondre aux valeurs de fin de comptage VAL_Wi, VAL_Rj , telles que programmées par l'utilisateur pour ces nouvelles valeurs de tension d'alimentation Vdd et de fréquence Freq.

La figure 2 illustre un organigramme de fonctionnement de la machine d'état SM implémentée dans l'interface mémoire MM_IF telle que présentée en référence à la figure 1.

Préalablement à l'étape S1, l'organigramme comprend donc une étape d'initialisation, non représentée, durant laquelle les moyens de programmation PROG déterminent, comme indiqué ci-avant, la valeur de durée d'indisponibilité VAL_W associée à une requête en écriture, et la valeur de durée d'indisponibilité VAL_R associée à une requête en lecture, et donc la valeur de fin de comptage des compteurs CT1 et CT2.

A l'étape S1, l'interface mémoire MM_IF indique à l'unité de traitement CPU que la mémoire vive MM est disponible car le signal de disponibilité HREADYout est à l'état haut.

L'unité de traitement CPU émet via le bus BS une requête d'accès RQT à destination de la mémoire vive MM, qui est réceptionnée par l'interface mémoire MM_IF.

A l'étape S2 suivante, la machine d'état SM détermine si la requête d'accès RQT reçue est destinée à lire ou écrire du contenu dans la mémoire vive MM.

Pour déterminer si la requête d'accès RQT est une requête en lecture ou en écriture, la machine d'état analyse par exemple un signal HWRITE délivré sur le bus BS (figure 3) indiquant à l'état haut une requête en écriture et à l'état bas une requête en lecture.

Selon le résultat déterminé à l'étape S2, l'étape suivante est soit l'étape S2-1 si la requête d'accès RQT est une requête en écriture, soit l'étape S2-2 si la requête d'accès RQT est une requête en lecture.

A partir des étapes S2-1, S2-2, l'organigramme se sépare en deux branches parallèles, la première branche comprend des étapes dédiées à la gestion d'une requête en écriture, la deuxième branche comprend des étapes dédiées à la gestion d'une requête en lecture.

A l'étape suivante S2-1 ou S2-2, la machine d'état SM transmet la requête d'accès RQT à la mémoire vive MM, via le bus mémoire BS_MM, en appliquant le protocole d'écriture ou de lecture classique.

Plus précisément comme illustré sur le chronogramme de la figure 3, le protocole d'écriture comporte des transitions sur les signaux classiques et connus CEN (« chip enable »), WEN (« write enable »), ainsi que l'envoi de la donnée à écrire et son adresse.

De même, le protocole de lecture comporte des transitions sur les signaux classiques et connus CEN (« chip enable »), WEN (« write enable »), ainsi que l'envoi de l'adresse de la donnée à lire.

A l'étape suivante S3-1 ou S3-2, la valeur de durée d'indisponibilité (valeur de fin de comptage) est comparée à la valeur zéro.

Si la valeur de durée d'indisponibilité est nulle la mémoire vive MM traite alors les requête d'accès RQT en écriture et/ou en lecture de manière classique, c'est à dire sans mettre en oeuvre de mécanisme d'état d'attente. Le signal HREADYout peut par exemple rester à l'état haut pour une nouvelle requête.

En revanche, si la valeur de durée d'indisponibilité en lecture ou en écriture est non nulle alors à l'étape correspondante S4-1 ou S4-2, les moyens de traitement MT indiquent à l'unité de traitement CPU la non disponibilité de mémoire vive MM en faisant passer le signal de disponibilité HREADYout à l'état bas.

A l'étape S5-1, ou respectivement S5-2, la machine d'état SM déclenche soit le premier compteur CT1 si la requête RQT est une requête en écriture, soit le deuxième compteur CT2 si la requête RQT est une requête en écriture, de sorte que seul le compteur concerné s'incrémente.

L'étape S6-1 ou S6-2 correspond à l'incrémentation du compteur concerné, CT1 ou CT2, à chaque cycle du signal d'horloge HCLK jusqu'à la valeur de fin de comptage.

A l'étape S7-1 ou S7-2, la durée d'indisponibilité est finalement écoulée, la mémoire vive MM peut donc traiter une nouvelle requête d'accès en provenance de l'unité de traitement CPU.

Les moyens de traitement MT indiquent de nouveau la disponibilité de la mémoire vive MM en remontant le signal de disponibilité HREADYout à l'état haut.

La figure 3 illustre un exemple de chronogramme de fonctionnement du système SYS tel que présenté en référence à la figure 1.

Le chronogramme illustre une gestion par le système SYS d'une requête d'accès en écriture d'une donnée, par exemple la donnée 11111111 à l'adresse 0005FFCC (ces deux valeurs étant en hexadécimal), immédiatement suivie d'une gestion d'une requête d'accès en lecture d'une donnée, par exemple la donnée précédemment écrite à cette même adresse. Des signaux relatifs à la gestion des requêtes sont donc transmis dans l'ensemble du système SYS sur le bus BS et le bus mémoire BS_MM. Les signaux circulant sur les bus BS et BS_MM sont cadencés par le signal d'horloge HCLK.

Sur le bus BS, des signaux émis par l'unité de traitement CPU comprennent :
- un signal de sélection HSEL pour activer la mémoire vive MM,
- un signal caractérisant la requête HWRITE en lecture ou en écriture,
- une information d'adresse HADDR désignant une adresse dans la mémoire vive MM à lire ou à écrire.

Par ailleurs, dans le cadre d'une requête en écriture, une donnée HWDATA à écrire dans la mémoire vive MM est transmise par l'unité de traitement CPU à l'interface mémoire MM_IF sur le bus BS.

Toujours sur le bus BS, les signaux émis par l'interface mémoire MM_IF comprennent :
- le signal de disponibilité HREADYout indiquant la disponibilité ou la non disponibilité de la mémoire vive MM, et
- dans le cadre d'une requête en lecture, une donnée HRDATA lue dans la mémoire transmise par l'interface mémoire MM_IF à l'unité de traitement CPU.

Sur le bus mémoire BS_MM, des données émises ou reçues par la mémoire vive MM comprennent :
- une adresse A correspondant à l'information d'adresse HADDR,
- une donnée d'entrée D à écrire dans la mémoire correspondant à la donnée à écrire HWDATA,
- une donnée de sortie Q lue dans la mémoire correspondant à la donnée lue HRDATA renvoyée vers l'unité de traitement CPU.

Toujours sur le bus mémoire BS_MM, des signaux générés par l'interface mémoire MM_IF à destination de la mémoire vive MM comprennent :
- le signal d'activation de puce CEN,
- le signal caractérisant la lecture ou l'écriture WEN,
- un signal d'horloge de la mémoire CLK généré à partir du signal d'horloge HCLK. La méthode de génération irrégulière du signal d'horloge de la mémoire CLK est obtenue par une méthode dite de suppression d'impulsion (appelée « pulse skipping » usuellement en anglais) permettant de limiter la consommation électrique grâce à la réduction du nombre de cycle d'horloge affectant l'état de la mémoire vive MM.

Enfin, la valeur courante du compteur CT2 est représentée sur le chronogramme. A des fins de simplifications seule la valeur courante du deuxième compteur CT2 associé à une lecture est représentée. En effet, dans l'exemple illustré seule la gestion de la requête d'accès en lecture met en oeuvre le mécanisme d'état d'attente. La valeur de fin de comptage du premier compteur CT1 est ici nulle.

Le chronogramme représente dans un premier temps l'émission par l'unité de traitement CPU d'une requête d'accès en écriture dans la mémoire vive MM de la donnée HWDATA à l'adresse HADDR.

La requête d'accès en écriture est caractérisée par la génération par l'unité de traitement CPU d'un état haut du signal de sélection HSEL et par un état haut du signal HWRITE.

L'interface mémoire MM_IF génère en conséquence, à un instant T1, un état bas du signal d'activation de puce CEN et un état bas du signal WEN. Ces deux signaux sont reçus par la mémoire vive MM et enclenchent l'écriture.

La mémoire vive MM traite alors la requête d'accès en écriture, entre l'instant T1 et un instant T2, la donnée d'entrée D prend la valeur la donnée à écrire HWDATA qui est écrite à l'adresse A représentative de l'information d'adresse HADDR.

La requête d'accès en écriture est traitée par le système SYS, dans cet exemple, en un seul cycle du signal d'horloge HCLK sans utiliser de cycles d'attente résultant du mécanisme de « wait state ».

Le signal de disponibilité HREADYout est maintenu à l'état haut durant l'intégralité de l'écriture de la donnée pour indiquer à l'unité de traitement CPU la disponibilité de la mémoire vive MM au prochain cycle du signal d'horloge HCLK.

La requête d'accès en lecture peut donc être traitée immédiatement au prochain cycle du signal d'horloge HCLK.

A cet égard, l'unité de traitement CPU émet une requête d'accès pour lire le contenu de la mémoire vive MM stocké à l'adresse HADDR.

La requête d'accès en lecture est caractérisée par la génération par l'unité de traitement CPU d'un état haut du signal de sélection HSEL et par un état bas du signal HWRITE.

L'interface mémoire MM_IF transmet, à un instant T3, la requête d'accès en lecture en générant un état bas du signal d'activation de puce CEN et un état haut du signal WEN. Ces deux signaux sont reçus par la mémoire vive MM, ce qui enclenche le processus de lecture sur le prochain front montant du signal CLK et le signal de disponibilité HREADYout passe à l'état bas, depuis l'instant T3 jusqu'à un instant T4.

Le compteur CT2 se déclenche et sa valeur courante s'incrémente jusqu'à la valeur de fin de comptage programmée par l'utilisateur, ici la valeur 2, correspondant à trois cycles d'horloge.

La durée d'indisponibilité associée à la requête en lecture est donc ici de trois cycles du signal d'horloge HCLK.

En conséquence, le signal de disponibilité HREADYout est maintenu à l'état bas durant les trois cycles d'horloge de la durée d'indisponibilité. L'émission d'une nouvelle requête d'accès par l'unité de traitement CPU est alors inhibée pendant ces trois cycles d'horloge.

Pendant ce temps, la mémoire vive MM traite la requête d'accès en lecture et restitue la donnée Q à l'interface mémoire MM_IF qui transmet la donnée lue HRDATA à l'unité de traitement.

## Revendications

1. Système, comprenant une mémoire vive (MM) connectée à une unité de traitement (CPU) par l'intermédiaire d'une interface mémoire (MM_IF),
- ladite interface mémoire comportant des moyens de réception (MRC) configurés pour recevoir une requête d'accès (RQT) à la mémoire émise par l'unité de traitement, et des moyens de traitement (MT) connectés aux moyens de réception et configurés pour indiquer à l'unité de traitement la non disponibilité de la mémoire vive pour recevoir une autre requête d'accès pendant une durée d'indisponibilité différentiable selon que la requête reçue est une requête en écriture ou en lecture,
le système comprenant en outre des moyens de programmation (PROG) configurés pour programmer individuellement indépendamment l'une de l'autre la valeur de la durée d'indisponibilité (VAL_W) associée à une requête en écriture et la valeur de la durée d'indisponibilité (VAL_R) associée à une requête en lecture,
système dans lequel l'unité de traitement (CPU) est cadencée par un signal d'horloge (HCLK), la valeur de la durée d'indisponibilité (VAL_W) associée à une requête en écriture correspond à un premier nombre de cycles du signal d'horloge (HCLK) et la valeur de la durée d'indisponibilité associée à une requête en lecture correspond à un deuxième nombre de cycles du signal d'horloge, et
les moyens de traitement comportent un premier compteur (CT1) cadencé par le signal d'horloge (HCLK) et ayant une première valeur de fin de comptage (VAL_Wi) correspondant à la valeur de la durée d'indisponibilité (VAL_W) associée à une requête en écriture, un deuxième compteur (CT2) cadencé par le signal d'horloge (HCLK) et ayant une deuxième valeur de fin de comptage (VAL_Rj) correspondant à la valeur de la durée d'indisponibilité (VAL_R) associée à une requête en lecture, et une machine d'état configurée pour déclencher le premier compteur (CT1) ou le deuxième compteur (CT2) si la première valeur de fin de comptage ou la deuxième valeur de fin de comptage est respectivement non nulle, pour délivrer un signal d'indisponibilité de la mémoire à l'unité de traitement lors du déclenchement de l'un des compteurs et délivrer un signal de disponibilité de la mémoire (MM) à l'unité de traitement lorsque le compteur ayant été déclenché a atteint sa valeur de fin de comptage, et
les moyens de programmation (MPRG) sont configurés en outre pour adapter de manière dynamique les valeurs de durées d'indisponibilité en lecture (VAL_R) et/ou en écriture (VAL_W) en fonction des valeurs courantes de la tension d'alimentation de la mémoire vive (Vdd) et de la fréquence du signal d'horloge (Freq).

2. Système selon la revendication 1, dans lequel la valeur de la durée d'indisponibilité (VAL_R) associée à requête en lecture est non nulle si la tension d'alimentation (Vdd) est inférieure à un premier seuil (TH1) et si la fréquence est supérieure à un deuxième seuil (TH2), et la valeur de la durée d'indisponibilité (VAL_W) associée à requête en écriture est non nulle si la tension d'alimentation (Vdd) est inférieure à un troisième seuil (TH3) et si la fréquence (Freq) est supérieure à un quatrième seuil (TH4).

3. Système selon l'une des revendication 1 à 2, dans lequel la durée d'indisponibilité (VAL_W) associée à une requête en écriture est inférieure ou égale à la durée d'indisponibilité (VAL_R) associée à une requête en lecture.

4. Système selon l'une des revendications précédentes, dans lequel les moyens de programmation (PROG) comportent un premier moyen de mémorisation (REG1) programmable connecté aux moyens de traitement (MT) et destiné à contenir une première indication représentative de la valeur de la durée d'indisponibilité associée à une requête en écriture (VAL_W), et un deuxième moyen de mémorisation (REG2) programmable connecté aux moyens de traitement (MT) et destiné à contenir une deuxième indication représentative de la valeur de la durée d'indisponibilité (VAL_R) associée à une requête en lecture.

5. Système selon la revendication 4, dans lequel ladite première indication est la première valeur de fin de comptage (VAL_Wi) et ladite deuxième indication est la deuxième valeur de fin de comptage (VAL_Rj).

6. Système selon l'une des revendications précédentes, formant un microcontrôleur.

## Patentansprüche

1. System, einen Direktzugriffsspeicher (MM) umfassend, der mittels einer Speicherschnittstelle (MM_IF) mit einer Verarbeitungseinheit (CPU) verbunden ist,
- wobei die Speicherschnittstelle Empfangsmittel (MRC) beinhaltet, die konfiguriert sind, um eine Zugriffsanforderung (RQT) an den Speicher zu empfangen, die von der Verarbeitungseinheit gesendet wurde, und Verarbeitungsmittel (MT), die mit den Empfangsmitteln verbunden sind und konfiguriert sind, um der Verarbeitungseinheit mitzuteilen, dass der Direktzugriffsspeicher nicht verfügbar ist, um eine andere Zugriffsanforderung während einer differenzierbaren Dauer der Nichtverfügbarkeit zu empfangen, gemäß der die empfangene Anforderung eine Schreib- oder Leseanforderung ist,
wobei das System ferner Programmiermittel (PROG) umfasst, die konfiguriert sind, um den Wert der Dauer der Nichtverfügbarkeit (VAL_W), der einer Schreibanforderung zugeordnet ist, und den Wert der Dauer der Nichtverfügbarkeit (VAL_R), der einer Leseanforderung zugeordnet ist, einzeln unabhängig voneinander zu programmieren,
System, wobei die Verarbeitungseinheit (CPU) durch ein Taktsignal (HCLK) getaktet wird, der Wert der Dauer der Nichtverfügbarkeit (VAL_W), der einer Schreibanforderung zugeordnet ist, einer ersten Anzahl von Zyklen des Taktsignals (HCLK) entspricht und der Wert der Dauer der Nichtverfügbarkeit, der einer Leseanforderung zugeordnet ist, einer zweiten Anzahl von Zyklen des Taktsignals entspricht, und
die Verarbeitungsmittel einen ersten Zähler (CT1) beinhalten, der vom Taktsignal (HCLK) getaktet wird und einen ersten Endzählwert (VAL_Wi) aufweist, der dem Wert der Dauer der Nichtverfügbarkeit (VAL_W) entspricht, der einer Schreibanforderung zugeordnet ist, einen zweiten Zähler (CT2), der vom Taktsignal (HCLK) getaktet wird, und einen zweiten Endzählwert (VAL_Rj) aufweist, der dem Wert der Dauer der Nichtverfügbarkeit (VAL_R) entspricht, der einer Leseanforderung zugeordnet ist, und eine Zustandsmaschine, die konfiguriert ist, um den ersten Zähler (CT1) oder den zweiten Zähler (CT2) auszulösen, wenn der erste Endzählwert beziehungsweise der zweite Endzählwert ungleich null ist, um ein Signal der Nichtverfügbarkeit des Speichers an die Verarbeitungseinheit zu liefern, wenn einer der Zähler ausgelöst wird, und ein Signal der Verfügbarkeit des Speichers (MM) an die Verarbeitungseinheit zu liefern, wenn der Zähler, der ausgelöst wurde, seinen Endzählwert erreicht hat, und
die Programmiermittel (MPRG) ferner konfiguriert sind, um die Werte der Lese-(VAL_R-) und/oder Schreib-(VAL_W-) Dauer der Nichtverfügbarkeit dynamisch in Abhängigkeit der aktuellen Werte der Versorgungsspannung des Direktzugriffsspeichers (Vdd) und der Taktsignalfrequenz (Freq) anzupassen.

2. System nach Anspruch 1, wobei der Wert der Dauer der Nichtverfügbarkeit (VAL_R), der der Leseanforderung zugeordnet ist, ungleich null ist, wenn die Versorgungsspannung (Vdd) kleiner als ein erster Schwellenwert (TH1) ist und wenn die Frequenz größer als ein zweiter Schwellenwert (TH2) ist, und der Wert der Dauer der Nichtverfügbarkeit (VAL_W), der der Schreibanforderung zugeordnet ist, ungleich null ist, wenn die Versorgungsspannung (Vdd) kleiner als ein dritter Schwellenwert (TH3) ist und wenn die Frequenz (Freq) größer als ein vierter Schwellenwert (TH4) ist.

3. System nach einem der Ansprüche 1 bis 2, wobei die Dauer der Nichtverfügbarkeit (VAL_W), die einer Schreibanforderung zugeordnet ist, kleiner oder gleich der Dauer der Nichtverfügbarkeit (VAL_R) ist, die einer Leseanforderung zugeordnet ist.

4. System nach einem der vorhergehenden Ansprüche, wobei die Programmiermittel (PROG) ein erstes programmierbares Speichermittel (REG1) beinhalten, das mit den Verarbeitungsmitteln (MT) verbunden ist, und dazu bestimmt ist, eine erste repräsentative Angabe des Werts der Dauer der Nichtverfügbarkeit (VAL_W), der einer Schreibanforderung zugeordnet ist, einzuschließen, und ein zweites programmierbares Speichermittel (REG2), das mit den Verarbeitungsmittel (MT) verbunden ist, und dazu bestimmt ist, eine zweite repräsentative Angabe des Werts der Dauer der Nichtverfügbarkeit (VAL_R), der einer Leseanforderung zugeordnet ist, einzuschließen.

5. System nach Anspruch 4, wobei die erste Angabe der erste Endzählwert (VAL_Wi) ist und die zweite Angabe der zweite Endzählwert (VAL_Rj) ist.

6. System nach einem der vorhergehenden Ansprüche, das einen Mikrocontroller bildet.

## Claims

1. A system, comprising a random access memory (MM) connected to a processing unit (CPU) via a memory interface (MMIF),
- said memory interface including reception means (MRC) configured to receive a memory access request (RQT) emitted by the processing unit, and processing means (MT) connected to the reception means and configured to indicate to the processing unit the unavailability of the random access memory to receive another access request during an unavailability duration that can be differentiated depending on whether the request received is a write or read request,
the system further comprising programming means (PROG) configured to individually program, independently of each other, the value of the unavailability duration (VAL_W) associated with a write request and the value of the unavailability duration (VAL_R) associated with a read request,
system wherein the processing unit (CPU) is clocked by a clock signal (HCLK), the value of the unavailability duration (VAL_W) associated with a write request corresponds to a first number of cycles of the clock signal (HCLK) and the value of the unavailability duration associated with a read request corresponds to a second number of cycles of the clock signal, and
the processing means include a first counter (CT1) clocked by the clock signal (HCLK) and having a first end of counting value (VAL_Wi) corresponding to the value of the unavailability duration (VAL_W) associated with a write request, a second counter (CT2) clocked by the clock signal (HCLK) and having a second end of counting value (VAL_Rj) corresponding to the value of the unavailability duration (VAL_R) associated with a read request, and a state machine configured to trigger the first counter (CT1) or the second counter (CT2) if the first end of counting value or the second end of counting value is respectively non-zero, to deliver a memory unavailability signal to the processing unit when one of the counters is triggered and deliver a memory availability signal (MM) to the processing unit when the counter having been triggered has reached its end of counting value, and
the programming means (MPRG) are further configured to dynamically adapt the values of the read (VAL_R) and/or write (VAL_W) unavailability duration according to the current values of the supply voltage of the random access memory (Vdd) and to the frequency of the clock signal (Freq) .

2. The system according to claim 1, wherein the value of the unavailability duration (VAL_R) associated with the read request is non-zero if the supply voltage (Vdd) is less than a first threshold (TH1) and if the frequency is greater than a second threshold (TH2), and the value of the unavailability duration (VAL_W) associated with the write request is non-zero if the supply voltage (Vdd) is less than a third threshold (TH3) and if the frequency (Freq) is greater than a fourth threshold (TH4).

3. The system according to one of claims 1 to 2, wherein the unavailability duration (VAL_W) associated with a write request is less than or equal to the unavailability duration (VAL_R) associated with a read request.

4. The system according to one of the preceding claims, wherein the programming means (PROG) include a first programmable storage means (REG1) connected to the processing means (MT) and intended to contain a first indication representative of the value of the duration of unavailability associated with a write request (VAL_W), and a second programmable storage means (REG2) connected to the processing means (MT) and intended to contain a second indication representative of the value of the duration of unavailability (VAL_R) associated with a read request.

5. The system according to claim 4, wherein said first indication is the first end of counting value (VAL_Wi) and said second indication is the second end of counting value (VAL_Rj) .

6. The system according to one of the preceding claims, forming a microcontroller.
